Europäisches Patentamt

European Patent Office

Office européen des brevets

(19)

(11) Publication number: **0 395 862**
**A2**

# (12) EUROPEAN PATENT APPLICATION

(21) Application number: **90104978.3**

(51) Int. Cl.⁵: **H01L 23/48**

(22) Date of filing: **16.03.90**

The title of the invention has been amended (Guidelines for Examination in the EPO, A-III, 7.3).

(30) Priority: **31.03.89 JP 81290/89**

(43) Date of publication of application:
**07.11.90 Bulletin 90/45**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Yamada, Yoshiki, c/o Intellectual Property Div.**
**Kabushiki Kaisha Toshiba, 1-1 Shibaura 1-chome**
**Minato-ku, Tokyo 105(JP)**
Inventor: **Yamaki, Bunshiro, c/o Intellectual Property Div.**
**Kabushiki Kaisha Toshiba, 1-1 Shibaura 1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Semiconductor device comprising a lead member.

(57) A semiconductor device comprises a semiconductor substrate (20) of one conductivity type having low resistivity, which is used as a conductive member and is mounted on a lead member (9d) held at a common electric potential, a first epitaxial layer (21) of one conductivity type having high resistivity and provided on the semiconductor substrate (20), a second epitaxial layer (22) of an opposite conductivity type provided on the first epitaxial layer (21), and at least one semiconductor layer (30) of one conductivity type having low resistivity, which reaches the semiconductor substrate (20) through both the second and first epitaxial layers (22, 21) so as to provide an electrical path to the lead member (9d) therethrough and is isolated from the second epitaxial layer (22) through a PN junction. A circuit element such as transistors and resistors is provided in each island region provided by the second epitaxial layer (22), and ground electrodes or their interconnection layers (26g) of the circuit elements are electrically connected to the semiconductor susbtrate (20) through the semiconductor layer (30), which serves as a lead member, without using a bonding wire (8d).

F I G. 1A

The present invention relates to a semiconductor device, and more particularly to a semiconductor integrated circuit device wherein no bonding wire is used as a lead member for a ground terminal.

A semiconductor device including circuit elements provided in a semiconductor chip, i.e. a monolithic integrated circuit, generally has features such as small size, light weight, low power consumption, low cost, high reliability, and high density, and is applied to electronic computers, TV receivers, radio receivers, cameras, automobiles, and the like.

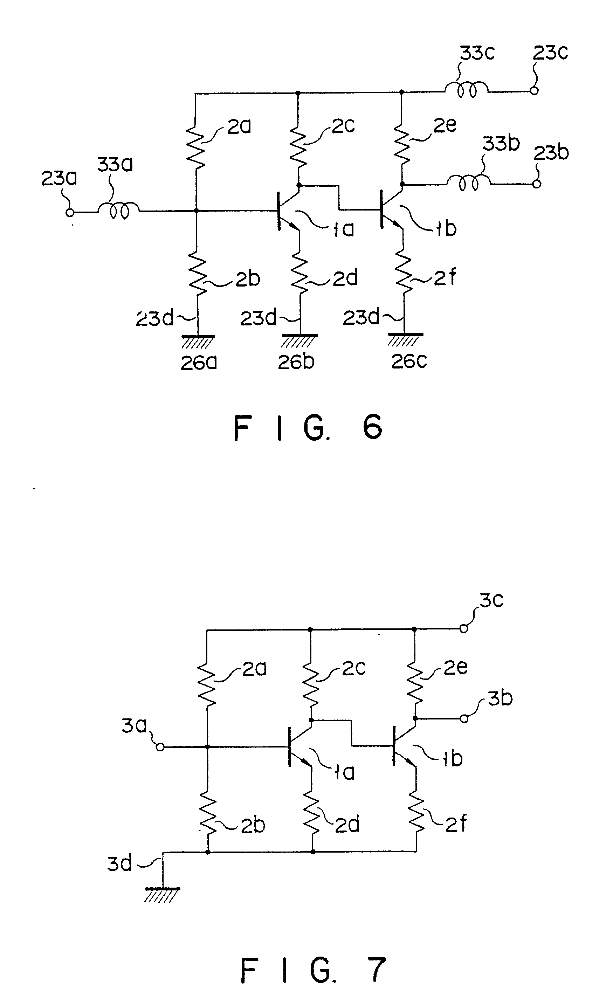

As an example of a conventional semiconductor device having a ground terminal, a direct coupled amplification semiconductor device in a monolithic integrated circuit will be described. Fig. 7 is a circuit diagram showing the direct coupled amplification semiconductor device. This semiconductor device comprises two transistors 1a and 1b, six resistors 2a to 2f, input terminal 3a, output terminal 3b, bias terminal 3c, and ground terminal 3d.

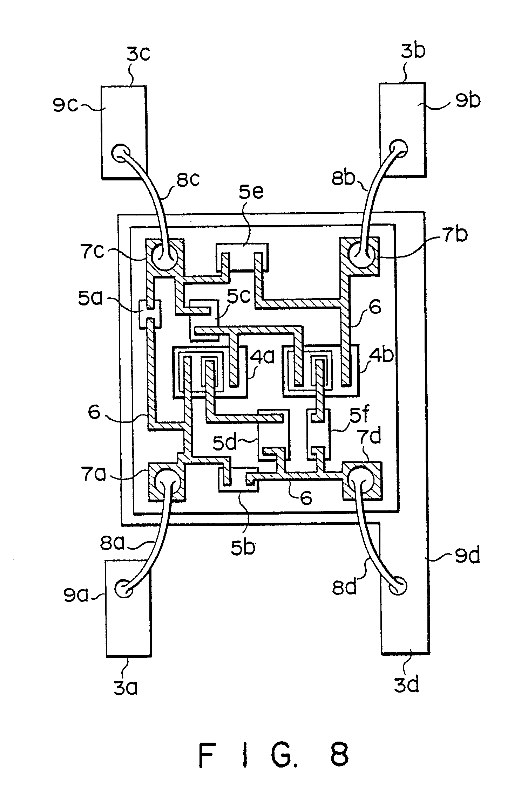

Fig. 8 illustrates a layout pattern of circuit elements of the semiconductor device shown in Fig. 7, which functions as a monolithic integrated circuit. The integrated circuit includes two transistor regions 4a and 4b and six resistor regions 5a to 5f. These regions are isolated from one another by a PN junction, and transistor elements and resistor elements are connected to one another by aluminum interconnection layers 6 (represented by oblique lines). Input terminal 3a, output terminal 3b, bias terminal 3c and ground terminal 3d are identical to lead members 9a to 9d respectively, and protrude from the package. Lead members 9a to 9d are connected to bonding pads 7a to 7d, provided on the chip, by means of their corresponding bonding wires 8a to 8d.

The following is an outline of the function of the integrated circuit described above. An input signal voltage applied between input and ground terminals 3a and 3d is amplified by transistors 1a and 1b and supplied through output and ground terminals 3b and 3d to an external circuit (not shown). Input terminal 3a, first transistor 1a, second transistor 1b and output terminal 3b are connected through a conductive member to provide a so-called direct coupled two-stage amplification circuit. The first function of resistors 2a to 2f is to divide a DC voltage applied between bias and ground terminals 3c and 3d so as to apply a desired bias voltage to collectors, bases and emitters of transistors 1a and 1b, thereby determining an operating point of each transistor. Resistors 2d and 2f are also called negative feedback resistors and perform a stable and reliable amplifying operation.

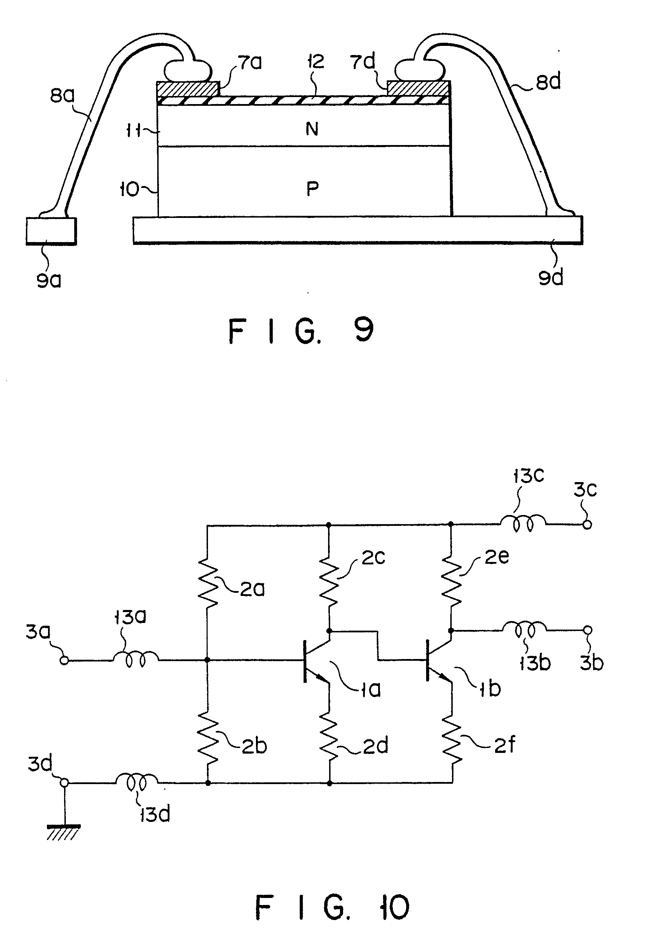

Fig. 9 is a cross-sectional view schematically showing the semiconductor device described above. The conventional semiconductor chip has an epitaxial layer 11 of one conductivity type (e.g., N-type) which is grown on a high resistivity semiconductor substrate 10 of an opposite conductivity type (e.g., P-type). Bonding pads 7a to 7d are provided on a silicon oxide film 12 formed on the epitaxial layer 11. The monolithic integrated circuit chip so constructed is mounted on a lead member 9d, and bonding pads 7a to 7d are connected to lead members 9a to 9d through bonding wires 8a to 8d.

As described above, in the conventional semiconductor device, since bonding pads 7a to 7d are connected to lead members 9a to 9d through bonding wires 8a to 8d, an inductance component caused by each bonding wire is added as a stray component. As illustrated in Fig. 10, an equivalent circuit in which the direct coupled amplification semiconductor device is monolithically integrated, includes inductance components 13a to 13d in addition to transistors and resistors. Among these stray inductance components the value of impedance caused by stray inductance component 13d connected to ground terminal 3d varies with signal frequencies. Since the stray inductance component is connected in series with the emitter resistor of transistor 1a or 1b through resistor 2d or 2f, the gain of transistors 1a and 1b is reduced. Particularly, the higher the signal frequency, the higher the impedance and the greater the effect of the stray inductance.

As has been described, a bonding wire has been used in the conventional monolithic semiconductor device having a ground terminal as a lead member for ground. Generally, stray inductance results from the bonding wires. In particular, the bonding wire for ground is used as a common current path through which an input current, an output current and a bias current flow, and is directly connected in series with the emitter of each transistor. Therefore, even if the value of the stray inductance is low, the influence of the stray inductance on the characteristics of the device, such as a reduction in gain, is too great to neglect. The impedance of the stray inductance component becomes higher in accordance with an increase in frequency and significantly degrades the high frequency characteristics, as well as other characteristics of the device.

Accordingly, it is an object of the present invention to provide a semiconductor device wherein disadvantages described above are eliminated to improve high frequency characteristics.

It is another object of the present invention to provide a semiconductor device for increasing the degree of freedom of layout pattern design of circuit elements on a chip.

A semiconductor device according to the present invention comprises (a) a semiconductor substrate of one conductivity type having low resistivity and used as a common electric potential terminal, (b) a first epitaxial layer of one conductivity type having high resistivity and provided on the semiconductor substrate, (c) a second epitaxial layer of an opposite conductivity type provided on the first epitaxial layer, and (d) at least one semiconductor layer of one conductivity type having low resistivity, which is selectively formed from the surface of the second epitaxial layer, reaches the semiconductor substrate through the second and first epitaxial layers, and is isolated from the second epitaxial layer through a PN junction.

Since the common potential terminal is mostly used as a ground potential, it is called a ground terminal or earth terminal, but its potential is not always limited to the ground potential. The common potential terminal is one of two terminals in an input terminal pair, an output terminal pair, or a bias power supply terminal pair (hereinafter referred to as a ground terminal). The lead member for the ground terminal is a conductive member for electrically connecting to the ground terminal electrodes of circuit elements to become the ground potential.

Since the semiconductor substrate of the above (a) serves as the ground terminal in addition to an inherent function as the substrate, its resistivity is very low. The second epitaxial layer of the above (c) selectively includes element regions for providing active circuit elements such as transistors, and passive circuit elements such as resistors. The epitaxial layer of the above (b) is interposed between the second epitaxial layer and semiconductor substrate and thus has high resistivity so as to obtain a desired isolation withstand voltage due to a PN junction. The semiconductor layer of one conductivity type of the above (d) is a column-shaped lead member which reaches depthwise the semiconductor substrate through second and first epitaxial layers from electrodes or interconnection layers of circuit elements whose electric potential is kept at the ground potential and which are selectively provided on the second epitaxial layer. The lead member also serves as a current path through which at least one of an input signal current, an output signal current and a bias current flows, and is constituted by the semiconductor layer with low resistivity. However, it is desirable that the cross section of the current path is small, in a range satisfying a desired resistance value. In the semiconductor device described above, since electrodes or interconnection layers of circuit elements provided on the chip, whose potential is to be kept at the ground potential, is electrically connected to the substrate, which also serves as the lead member, through the semiconductor layer with low resistivity in place of the conventional bonding wire, unwanted stray inductance will be greatly reduced. Furthermore, since unwanted extension of interconnection layers for ground and a bonding pad for ground provided on the chip are reduced, the element forming regions can be enlarged.

The novel and distinctive features of the invention are set forth in the claims appended to the present application. The invention itself, however, together with further objects and advantages thereof may best be understood by reference to the following description and accompanying drawings in which:

Figs. 1A and 1B are cross-sectional views along the lines $X_1$ - $X_1$ and $X_2$ - $X_2$ of Fig. 2, showing a semiconductor device according to one embodiment of the present invention;

Fig. 2 is a layout pattern of the semiconductor device shown in Fig. 1;

Fig. 3 is a circuit diagram showing an equivalent circuit of the semiconductor device shown in Fig. 1;

Fig. 4 is a cross-sectional view showing a semiconductor device according to another embodiment of the present invention;

Fig. 5 is a layout pattern of the semiconductor device shown in Fig. 4;

Fig. 6 is a circuit diagram showing an equivalent circuit of the semiconductor device shown in Fig. 4;

Fig. 7 is a circuit diagram showing a conventional semiconductor device;

Fig. 8 is a layout pattern of the conventional semiconductor device shown in Fig. 7;

Fig. 9 is a cross-sectional view showing the semiconductor device shown in Fig. 8; and

Fig. 10 is a circuit diagram showing an equivalent circuit of the semiconductor device shown in Fig. 8.

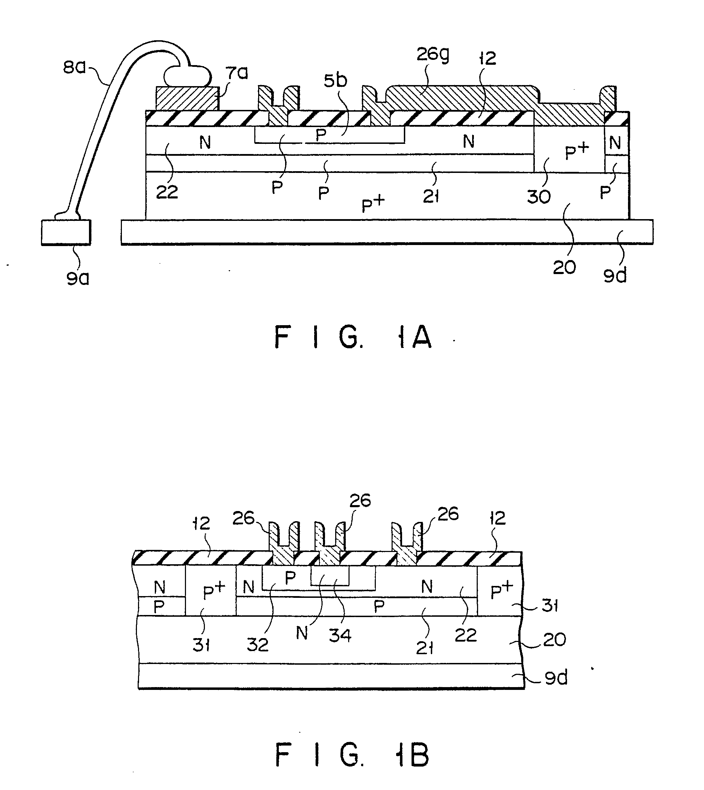

One embodiment of the present invention will be described with reference to the accompanying drawings of Figs. 1A to 3. A semiconductor device according to this embodiment is a direct coupled amplification semiconductor device. Since the same reference numerals in Figs. 1A to 3 and in Figs. 7 to 9 denote the same components, the description of the same components shown in Figs. 7 to 9 will be omitted.

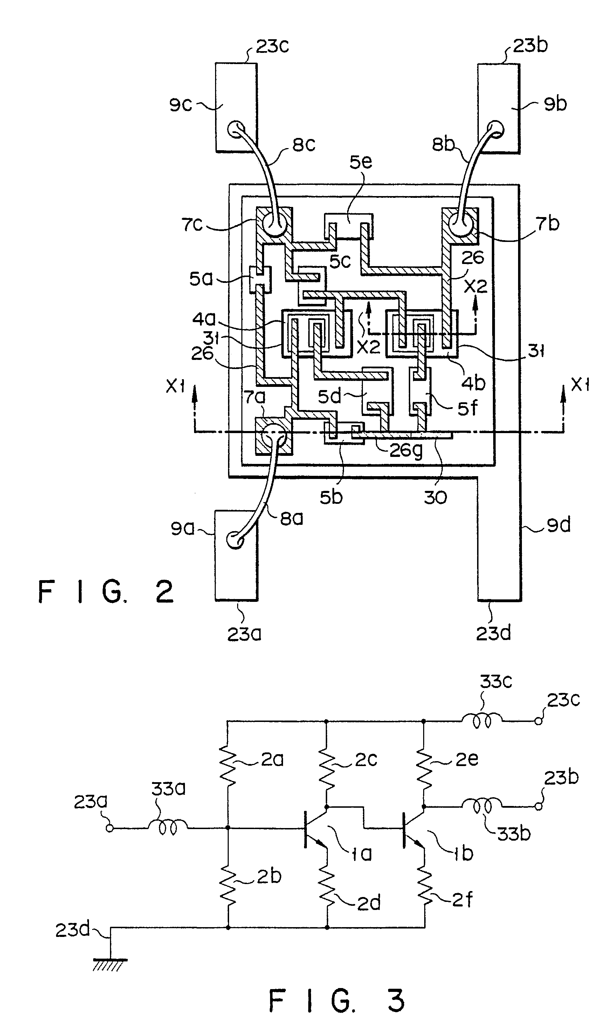

Figs. 1A and 1B are cross-sectional views along the lines $X_1$ - $X_1$ and $X_2$ - $X_2$ of the layout pattern shown in Fig. 2, respectively. As illustrated in Fig. 1A, low-resistivity semiconductor substrate 20 of one conductivity type (P-type) having a thickness of 500 to 600 $\mu$m and an impurity concentration of $1 \times 10^{20}$ atoms/cm$^3$ is prepared. High-resistivity P-type first epitaxial layer 21 having a thickness of 20 to 25 $\mu$m and an impurity concentration of $4 \times 10^{14}$ atoms/cm$^3$ is grown on P$^+$-

type substrate 20. Further, second epitaxial layer 22 of an opposite conductivity type (N-type) having a thickness of 2 to 5 $\mu$m and an impurity concentration of 1 × 10$^{16}$ atoms/cm$^3$ is grown on the first epitaxial layer 21. Thereafter, P-type impurity such as boron (B) is selectively diffused from the surface of second epitaxial layer 22 by means of ion implantation or thermal diffusion techniques to form P$^+$-type semiconductor layer 30 with low resistivity (impurity concentration 5 × 10$^{18}$ atoms/cm$^3$) which extends to P$^+$-type substrate 20 through the second and first epitaxial layers. A region to diffuse the impurity from the surface of second epitaxial layer 22 is a desired selected region just under an interconnection layer for ground potential (including an electrode, hereinafter referred to as a ground electrode interconnection layer) in interconnection layers formed in the subsequent process.

As shown in Fig. 1B, a transistor isolation region 31 is also formed by such impurity diffusion process. Using well-known techniques, P-type base region 32, resistor region 5b and N-type emitter region 34 are formed in the second epitaxial layer to provide circuit elements such as transistors and resistors. Next, contact windows are formed in a silicon oxide film 12 on the second epitaxial layer to provide interconnection layers 26 including aluminum electrodes. In this case, a ground electrode interconnection layer 26g is in contact with P$^+$-type semiconductor layer 30. After the semiconductor substrate 20 is lapped to a thickness of 130 to 150 $\mu$m, it is attached by soldering or the like to a lead member 9d which serves as a ground terminal.

Fig. 2 is a layout pattern of the semiconductor device according to the embodiment of the present invention. As in the prior art device, input terminal 23a, output terminal 23b and bias terminal 23c are connected to bonding pads 7a to 7c through both lead members 9a to 9c and bonding wires 8a to 8c, respectively. In this embodiment, electrodes to become ground potential in electrodes of circuit elements are electrodes provided at one side of each of resistor regions 5b, 5d and 5f, and these ground potential electrodes are connected to one another through ground electrode interconnection layer 26g. In a selected region formed just under the electrode interconnection layer 26g, P$^+$-type semiconductor layer 30, which is in contact with the selected region and extends to the substrate 20, has been provided. The substrate 20 is mounted on the lead member 9d including the ground terminal 23d.

According to the structure described above, the ground electrode interconnection layer 26g on the chip can be electrically connected to the lead member 9d through both P$^+$-type semiconductor layer 30 and the semiconductor substrate 20.

Therefore, it is unnecessary to connect the ground electrode interconnection layer 26g to the lead member 9d by using the bonding wire, thereby utilizing no bonding pad and bonding wire.

Fig. 3 is a circuit diagram showing an equivalent circuit of the semiconductor device according to the embodiment of the present invention. In this embodiment, since no bonding wire for ground terminal is used, there is no stray inductance. The stray inductance of P$^+$-type semiconductor layer 30, which connects the ground electrode interconnection layer and the lead member to each other in place of the bonding wire, is so small as to be virtually insignificant. In the equivalent circuit, therefore, the stray inductance component is not added to the ground terminal side.

When the semiconductor device described above is operated, a PN junction provided between P$^+$-type semiconductor layer 30 and second epitaxial layer 22 is reverse-biased to isolate them to each other. P$^+$-type semiconductor layer 30 serves as a common current path through which an input current, an output current and a bias current flow. However, a synthesized current of these currents is not affected by the stray inductance.

For this reason, the semiconductor device according to the embodiment of the present invention is much more superior in gain-frequency characteristics as compared with the prior art devices and, in particular, the characteristic deterioration at high frequency regions of frequency bands in use is remarkably improved.

Since the number of bonding wires is decreased by one, there is a decrease in the occurrence of defects caused by the bonding wire, thereby improving the reliability of the semiconductor device. Further, since no bonding pad for the ground terminal is required, the element forming regions can be increased.

In the embodiment described above, there is provided the semiconductor device in which the ground electrode interconnecting layer 26g formed on the substrate surface is electrically connected to the semiconductor substrate 20 through only one P$^+$-type semiconductor layer 30. However, the number of P$^+$-type semiconductor layers is not limited to one.

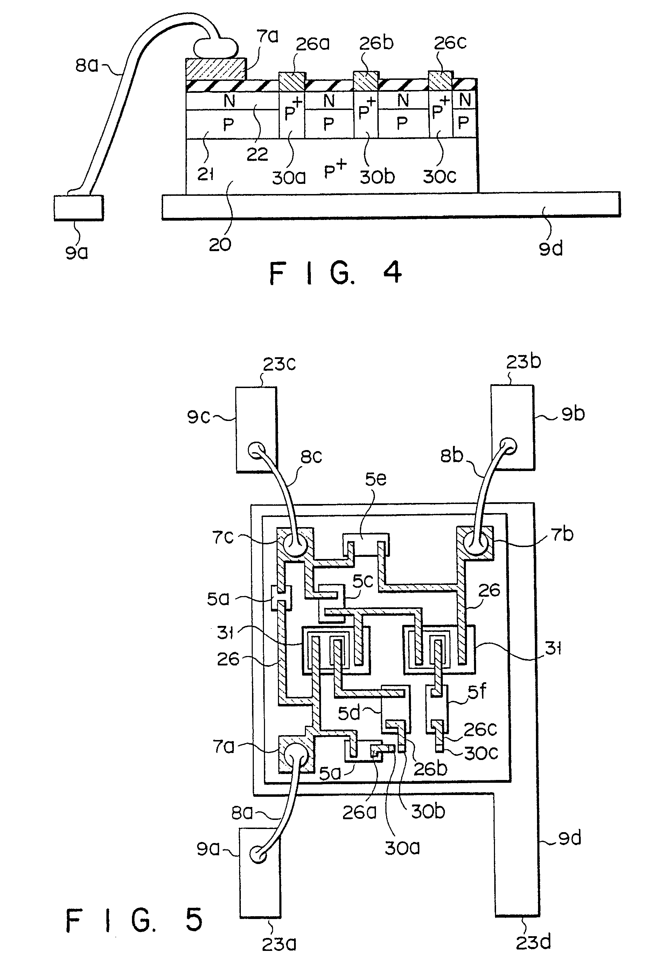

Another embodiment of the present invention will be described with reference to accompanying drawings of Figs. 4 to 6. As illustrated in Fig. 4, ground electrode interconnection layers may be electrically connected to a semiconductor substrate through a plurality of P$^+$-type semiconductor layers 30a, 30b and 30c. In this case, a layout pattern and an equivalent circuit of such a semiconductor device are shown in Figs. 5 and 6, respectively. In Figs. 4 to 6, reference numerals 26a, 26b and 26c denote ground electrode interconnection layers provided at one end of each of resistor regions 5b, 5d and 5f (or resistors 2b, 2d and 2f), and all of such ground electrode interconnection layers are electrically connected to the semiconductor substrate 20 through P$^+$-type semiconductor layers 30a, 30b and 30c, respectively. In this embodiment, each P$^+$-type semiconductor layer is located just under each ground electrode interconnection layer which includes an electrode to be kept at a ground potential and which is close to the electrode. Accordingly, it is possible to perform the electrical connection between electrode interconnection layers and the semiconductor substrate 20 every circuit elements. Unlike the prior art device, it is unnecessary to extend ground electrode interconnection layers on the semiconductor chip. The degree of freedom of layout pattern design can be greatly increased and the element forming regions can be enlarged, thereby improving the integration density.

In the embodiments described above, there have been provided semiconductor devices in which P-type is used as one conductivity type while N-type is used as opposite conductivity type. However, the conductivity types (P- and N-types) can be of course exchanged with each other.

Further, the direct coupled amplification semiconductor device has been described in the above embodiments as monolithic integrated circuits. However, the invention is not limited to such semiconductor device. More specifically, the present invention can be applicable to monolithic semiconductor devices having at least two terminal pairs of an input terminal pair, an output terminal pair and a bias terminal pair, and using one of the paired terminals as a common potential terminal.

It is further understood by those skilled in the art that the foregoing description is preferred embodiments of the disclosed devices and that various changes and modifications may be made in the invention without departing from the spirit and scope thereof.

Reference signs in the claims are intended for better understanding and shall not limit the scope.

**Claims**

1. A semiconductor device characterized by comprising:
a lead member (9d) held at a common electric potential;
a semiconductor substrate (20) of one conductivity type having low resistivity, said semiconductor substrate (20) being used as a conductive member, said semiconductor substrate (20) being mounted on said lead member (9d);
an epitaxial layer (22) of an opposite conductivity type provided on said semiconductor substrate (20); and
at least one semiconductor layer (30, 30a to 30c) of one conductivity type having low resistivity, said semiconductor layer (30, 30a to 30c) reaching said semiconductor substrate (20) through said epitaxial layer (22), said semiconductor layer (30, 30a to 30c) being isolated from said epitaxial layer (22) through a PN junction, whereby said semiconductor layer (30, 30a, to 30c) provides an electrical path to said lead member (9d) through said semiconductor substrate (20).

2. The semiconductor device according to claim 1, characterized in that said semiconductor layer (30, 30a to 30c) is a column-shaped lead member.

3. A semiconductor device characterized by comprising:
a lead member (9d) held at a common electric potential;
a semiconductor substrate (20) of one conductivity type having low resistivity, said semiconductor substrate (20) being used as a conductive member, said semiconductor substrate (20) being mounted on said lead member (9d);
an epitaxial layer (22) of an opposite conductivity type provided on said semiconductor substrate (20);
a plurality of isolation regions (31) of one conductivity type provided in said epitaxial layer (22), said isolation regions (31) reaching said semiconductor substrate (20) through said epitaxial layer (22);
a plurality of island regions of an opposite conductivity type isolated by said isolation regions (31), said island regions being provided by said epitaxial layer (22);
a circuit element (1a, 1b, 2a to 2f) provided in each of said island regions; and
at least one semiconductor layer (30, 30a to 30c) of one conductivity type having low resistivity, said semiconductor layer (30, 30a to 30c) reaching said semiconductor substrate (20) through said epitaxial layer (22), said semiconductor layer (30, 30a to 30c) being isolated from said epitaxial layer (22) through a PN junction, whereby said semiconductor layer (30, 30a to 30c) provides an electrical path to said lead member (9d) through said semiconductor substrate (20).

4. The semiconductor device according to claim 3, characterized in that said semiconductor layer (30, 30a to 30c) is a column-shaped lead member.

5. The semiconductor device according to claim 3, characterized in that selected electrodes (26, 26g, 26a to 26c) of said circuit elements (2b, 2d, 2f) are electrically connected to said semiconductor substrate (20) through said semiconductor layer (30, 30a to 30c), without using a bonding wire (8d), thereby keeping said electrodes (26, 26g, 26a to 26c) at a common electric potential.

F I G. 1A

F I G. 1B

F I G. 2

F I G. 3

F I G. 4

F I G. 5

F I G. 6

F I G. 7

F I G. 8

F I G. 9

F I G. 10